# EUROPEAN PATENT SPECIFICATION

(11) **EP 4 560 635 B1**
(45) Date of publication and mention of the grant of the patent: **12.08.2026**
(21) Application number: 23211899.2
(22) Date of filing: 24.11.2023
(51) Int. Cl.: G11C 11/18, H10B 61/00, G11C 11/16, G11C 19/08

(54) **A HIGH DENSITY 3D MAGNETIC MEMORY DEVICE**
HOCHDICHTE 3D-MAGNETSPEICHERVORRICHTUNG
DISPOSITIF DE MÉMOIRE MAGNÉTIQUE 3D À HAUTE DENSITÉ

(43) Date of publication of application: 28.05.2025
(73) Proprietor: Vertical Compute SRL, 1348 Ottignies-Louvain-la-Neuve (BE)
(72) Inventor: Couet, Sebastien, 1390 Grez-Doiceau (BE); Yasin, Farrukh, 3000 Leuven (BE); Gama Monteiro Junior, Maxwel, 3010 Leuven (BE)
(74) Representative: Roth, Sebastian

(56) References cited:
- US-A1- 2020 303 624
- US-A1- 2021 083 001
- US-A1- 2021 125 653
- US-A1- 2021 249 061

## Description

### TECHNICAL FIELD

The present disclosure relates to magnetic memory devices. In particular, the present disclosure presents a new kind of three-dimensional (3D) magnetic memory device that may achieve a high memory density (bit density). The magnetic memory device of this disclosure is based on a spin orbit torque (SOT) magnetic random access memory (MRAM) device architecture.

### BACKGROUND

In the field of computing devices, a very large variety of memory architectures have been developed over the last decades depending on various technical constraints, for instance, depending on speed requirements, memory requirements, density requirements, and application type. For example, the static random-access memory (SRAM) architecture has been exploited for its high operating speed, but with the drawback related to its areal density. By contrast, the dynamic random-access memory (DRAM) architecture allows for a high capacity working memory, but at lower speed. Moreover, (3D) NAND provides cheap high capacity, but is extremely slow compared to the other memory types. More recent advances introduced the spin-transfer torque magnetic random-access memory (STT-MRAM) architecture, a non-volatile resistive memory exploiting a magnetic tunnel junction (MTJ).

STT-MRAM is seen as an embedded memory (built on the same die as logic), because of its relatively fast operation speeds (down to a few nanoseconds), robust endurance, and compatibility with advanced complementary metal-oxide semiconductor (CMOS) voltages. It also offers non-volatility by storing bits in a magnetic state, and therefore presents an improvement in leakage power compared to alternatives in SRAM and DRAM.

Various flavors of magnetic memories exist, with STT-MRAM being the most advanced, but SOT-MRAM and voltage controlled MRAM being potential next generation candidates with possibilities for even faster speeds and/or lower power operation. Nevertheless, all of these magnetic memories are based on the MTJ technology. Since the MRAM stack itself is often a complex collection of over 20 individual ultra-thin layers, the use of physical vapor deposition (PVD) is needed which implies a planar configuration.

While the MRAM technologies described above make good candidates for SRAM replacement or on-chip memory, the planar configuration ultimately limits the achievable memory density, thus limiting their application to embedded memory technology, where the current density offering is limited. To target other parts of the memory pyramid, MRAM would have to exploit the third dimension, in order to potentially increase the memory density by a factor of about 100, while ideally preserving and controlling the known advantages of MRAM regarding speed and endurance.

### SUMMARY

In view of the above, the present disclosure aims to provide a new kind of magnetic memory device that is based on MRAM. An objective is, in particular, to exploit all three dimensions, i.e., to depart from the planar configuration and provide a 3D magnetic memory device. An ultimate objective is thereby to significantly increase the achievable memory density for storing more information in the magnetic memory device.

These and other objectives are achieved by the invention described in the independent claims. Advantageous implementations are described in the dependent claims.

A first aspect of this invention provides a 3D magnetic memory device, the 3D magnetic memory device comprising: a stack comprising a plurality of dielectric layers and silicon-based layers, which are alternatingly arranged one on the other;
a magnetic channel that extends through the layers of the stack, wherein the magnetic channel comprises a hollow cylinder made of a magnetic material, and a dielectric material that fills the hollow cylinder; wherein a plurality of pinning sites defined by the plurality of layers of the stack is formed in the magnetic channel, each pinning site being configured to store one magnetic bit; a first metallic layer arranged on a first end of the magnetic channel and on the last layer of the stack; a magnetic tunnel junction, MTJ, arranged on the first metallic layer; and a first electrode arranged on the first metallic layer at a distance to the MTJ; wherein either the first metallic layer is configured as a spin-orbit-torque, SOT, track, or the magnetic memory device comprises a second metallic layer configured as a SOT track and a second end of the magnetic channel and the first layer of the stack are arranged on the second metallic layer.

The magnetic channel constitutes a memory cell of the 3D magnetic memory device of the first aspect. The magnetic channel stores a plurality of magnetic bits along its length, one for each layer of the stack. The pinning sites are generated by the alternatingly layers and their interfaces. The pinning sites are locations where magnetic domains (or more specifically, the domain walls that separate these domains) are "pinned" or stabilized. Thus, each pinning site is configured to stabilize (and thus configured to store) a particular magnetic state in the magnetic channel, the magnetic state representing a (magnetic) bit of information.

The magnetic channel may accordingly store a bit sequence. The magnetic memory device may comprise multiple such magnetic channels formed in multiples stacks in the same way as described above, in order to implement multiple memory cells of the magnetic memory device. The multiple magnetic channels may thereby be arranged in parallel to each other and/or may be arranged in an array of magnetic channels, for instance, an array comprising a plurality of rows and columns. That is, the magnetic channels may be arranged in a 2D array and may extend along the third dimension. Thus, the 3D magnetic memory device of the first aspect can exploit all three dimensions, and depart from the usual planar configuration. Consequently, the magnetic memory device of the first aspect may have a significantly increased memory density, and can store more information that a conventional, planar magnetic memory device.

Furthermore, the magnetic memory device of the first aspect employs SOT for writing information into the magnetic channel of the memory cell, and can employ TMR using the MTJ to read out information from the magnetic channel of the memory cell. Moreover, information can be moved in the magnetic channel by a push current, and thus moving magnetic bits stored in the magnetic channel from one pinning site to the next. The pinning sites are enabled by the periodicity of the layer stack, and are able to stabilize a magnetic domain within a single layer height. Hence, the height of a magnetic bit can be defined by said periodicity.

The magnetic channel of the magnetic memory device of the first aspect provides further advantages, due to its configuration as a "macaroni" type channel comprising the hollow magnetic cylinder and the dielectric filling, compared to an exemplary similar device, which has a full magnetic material channel with a varying diameter.

In such an exemplary device, the shape anisotropy of the magnetic material channel is what forces the magnetization to align along the axis of the magnetic material channel, as it extends through the stack (e.g., the vertical axis). An aspect ratio *t*/*CD* between an individual thickness *t* of the layers of the stack and a critical dimension (*CD*), which can guarantee this, is at least 2-3, i.e., *t >* 2-3**CD*. Normally the overall shape anisotropy helps to make sure that all magnetization remains perpendicular, even if the individual bit *t*/*CD* ratio is much smaller. For instance, *CD* may be in the range of 30-50 or 30-80 nm, while *t* may be in a range of 15-50 nm.

However, there is a risk that different bit sequences written into the magnetic channel (e.g. {111111} vs. {1010101} vs. {000001}, for example) could contribute at different degrees to the alteration of the shape anisotropy effect, which may lead to a weakening of that effect for some of those configurations. However, scaling further the device (for example, down to 20 nm *CD*) remains challenging, as it is costly, requires intensive lithography steps, and meets limitations due to the high aspect ratio, in particular for etching.

Another issue is that the magnetic domain pinning occurs only in every other layer in this exemplary device, instead of between each of the layers. Therefore, magnetic information can only be stored every bi-layer, which limits the total amount of information that the magnetic channel can bear. This halves the potential of the 3D magnetic memory device.

The magnetic macaroni channel used in this disclosure reduces the active magnetic channel diameter, which leads to a lower pushing current. Moreover, the magnetic channel allows for a more relaxed *CD* while keeping low current. This enables a cheaper fabrication, or an easier manufacturing in terms of *CD* control. In addition, the magnetic domains have reinforced magnetic anistropy, which makes the memory devicve more stable. Potentially, the memory device may lead up to a doubling of the bit density, because magnetic bits are stored adjacent to all layers of the stack.

In an implementation of the 3D magnetic memory device, the magnetic channel has a first diameter where it extends through a silicon-based layer and has a second diameter where it extends through a dielectric layer of the stack.

In an implementation of the 3D magnetic memory device, the first diameter is larger than the second diameter.

This may allow adjusting the pinning strength of the respective pinning sites in the magnetic channel. Thus, also the performance of the magnetic memory device, for instance, regarding its retention and latency, can be tailored.

In an implementation of the 3D magnetic memory device, a ratio between the first diameter and the second diameter is in a range of 1.1:1 to 2:1.

A smaller ratio may be used to favor latency, while a larger ratio may be used to favor retention time of the magnetic memory device.

In an implementation of the 3D magnetic memory device, transitions between the first diameter and the second diameter are aligned with interfaces between the alternatingly arranged layers of the stack.

In an implementation of the 3D magnetic memory device, the hollow cylinder is a stepped hollow cylinder.

In an implementation of the 3D magnetic memory device, the stepped hollow cylinder has a constant wall thickness.

In an implementation of the 3D magnetic memory device, at the first end of the magnetic channel, an inner core of the hollow cylinder has a radius of up to 100 nm or in a range of 10-80 nm.

This facilitates reading of the magnetic bit closest to the MTJ.

In an implementation of the 3D magnetic memory device, the MTJ is arranged directly above the first end of the magnetic material channel on the first metallic layer, or is arranged offset from the first end of the magnetic material channel.

In an implementation of the 3D magnetic memory device, the MTJ comprises a magnetic free layer having a coercivity of equal to or less than 20-40 mT, or a coercivity in a range of 2-3 mT.

Thus, the stray magnetic field of the pinning site closest to the MTJ may determine the orientation of the free layer.

In an implementation of the 3D magnetic memory device, a thickness of the silicon-based layers and the dielectric layers is respectively in range of 5-150 nm.

In an implementation of the 3D magnetic memory device, a length of the magnetic channel along an extension direction of the magnetic channel through the stack is in a range of 5-150 nm times the number of layers of the stack.

In an implementation of the 3D magnetic memory device, the magnetic material of the hollow cylinder is a ferromagnetic or ferrimagnetic material and/or a conductive material, for example, is cobalt, iron, nickel, or an alloy thereof, or is any of the former in addition to boron.

In an implementation of the 3D magnetic memory device, the dielectric layers are silicon oxide layers and the silicon-based layers are silicon nitride layers, or the dielectric layers are silicon layers and the silicon-based layers are silicon germanium layers; and/or the dielectric material that fills the hollow cylinder is silicon oxide.

In an implementation of the 3D magnetic memory device, at least one of the first metallic layer and the second metallic layer is made of tantalum nitride, tungsten nitride, tungsten, tantalum, platinum, hafnium, molybdenum, molybdenum nitride, or alloys thereof, or is made of a topological insulator.

These materials may allow using either the first metallic layer or the second metallic layer as an SOT track. That is, this enables sending an SOT current through the first or second metallic layer, in order to write a magnetic bit into the magnetic channel of the memory cell.

In an implementation, the 3D magnetic memory device further comprises a second electrode arranged on or directly below a second end of the magnetic channel.

The second electrode facilitates sending a push current through the magnetic channel towards the first electrode.

A second aspect of this invention provides a method of fabricating a 3D magnetic memory device, the method comprising: forming a stack of a plurality of dielectric layers and silicon-based layers, which are alternatingly arranged one on the other; forming a hole that extends through the layers of the stack; depositing a magnetic material onto the sidewalls of the hole, in order to form a hollow cylinder made of the magnetic material; filling the hollow cylinder with a dielectric material, in order to form a magnetic channel comprising the hollow cylinder and the dielectric material; wherein a plurality of stacked pinning sites defined by the plurality of layers of the stack is formed in the magnetic channel, each pinning site being configured to store one magnetic bit; forming a first metallic layer on a first end of the magnetic channel and on the last layer of the stack; forming a magnetic tunnel junction, MTJ, on the first metallic layer; and forming a first electrode on the first metallic layer at a distance to the MTJ; wherein either the first metallic layer is configured as a spin-orbit-torque, SOT, track, or the method further comprises forming a second metallic layer configured as a SOT track and arranging a second end of the magnetic channel and the first layer of the stack on the second metallic layer.

In an implementation, the method comprises: after forming the hole, selectively etching from within the hole to recess either the dielectric layers or the silicon-based layers, in order to partially broaden the hole; and depositing the magnetic material onto the sidewalls of the recessed hole, in order to form a stepped hollow cylinder made of the magnetic material.

In an implementation of the method, the magnetic material is formed by conformal deposition on the sidewalls of the hole and/or is deposited to a thickness in a range of 5-20 nm.

The method of the second aspect leads to the same advantages as described above for the magnetic memory device of the first aspect. The method of the second aspect may be extended by respective implementations to produce the implementations of the magnetic memory device of the first aspect described above.

A third aspect of this disclosure outside the scope of the present invention provides a method of operating the 3D magnetic memory device of the first aspect or any implementation thereof, wherein the method comprises at least one of the following operations: writing a magnetic bit into the magnetic channel by passing a current through the SOT track, wherein the magnetic bit is written into the pinning site in the magnetic channel that is closest to the SOT track; pushing magnetic bits along the magnetic channel from one pinning site to the next pinning site by passing a current through the first electrode; reading a magnetic bit from the magnetic channel by passing a current through the MTJ and thereby determining a tunnel-magnetoresistance, wherein the magnetic bit stored in the pinning site in the magnetic channel that is closest to the MTJ is read.

The method of the third aspect allows to perform a write operation, a read operation, or a push operation, with the magnetic memory device of the first aspect, particularly, in the memory cell of the magnetic memory device comprising the magnetic channel. Similar operations can be performed, subsequently or in parallel, on different memory cells of the magnetic memory device.

In an implementation of the method, the magnetic memory device comprises the second electrode, and pushing the magnetic bits comprises sending the current from the second electrode to the first electrode; or the magnetic memory device does not comprise the second electrode but comprises the second metallic layer, and pushing the magnetic bits comprises sending the current from the second metallic layer to the first electrode; or the magnetic memory device comprises the second electrode and the first metallic layer is configured as the SOT track, and pushing the magnetic bits comprises sending a bi-polar current from the second metallic layer to the first electrode.

The above implementation provides different ways of performing the push operation with the magnetic memory device of the first aspect.

In an implementation of the method, when pushing the magnetic bits stored in the magnetic channel, the magnetic bit stored in the pinning site in the magnetic material that is closest to the first metallic layer is destructed, and the method further comprises: re-writing the destructed magnetic bit into the magnetic channel or storing the information corresponding to the destructed magnetic bit in a memory.

### BRIEF DESCRIPTION OF THE DRAWINGS

The above described aspects and implementations are explained in the following description of embodiments with respect to the enclosed drawings:
- FIG. 1: shows an example of a magnetic memory device according to this invention with a bottom SOT track.
- FIG. 2: shows another example of a magnetic memory device according to this invention with a top SOT track.
- FIG. 3: shows another example of a magnetic memory device according to this invention having a magnetic channel with a step-like varying diameter.
- FIG. 4: shows another example of a magnetic memory device according to this invention with an out-of-plane MTJ.
- FIG. 5: shows another example of a magnetic memory device according to this invention with a bottom electrode.
- FIG. 6: shows another example of a magnetic memory device according to this invention without the bottom electrode but with a further top electrode.
- FIG. 7: shows a flow-diagram of a method for fabricating a magnetic memory device according to this invention.
- FIG. 8: illustrates a first example of the method for fabricating a magnetic memory device according to this invention with a magnetic channel having a constant diameter.
- FIG. 9: illustrates a second example of the method for fabricating a magnetic memory device according to this invention with a magnetic channel having a step-like varying diameter.
- FIG. 10: shows an example of writing a magnetic bit into a magnetic memory device according to this disclosure.
- FIG. 11: shows an example of pushing magnetic bits in a magnetic memory device according to this disclosure.

### DETAILED DESCRIPTION OF EMBODIMENTS

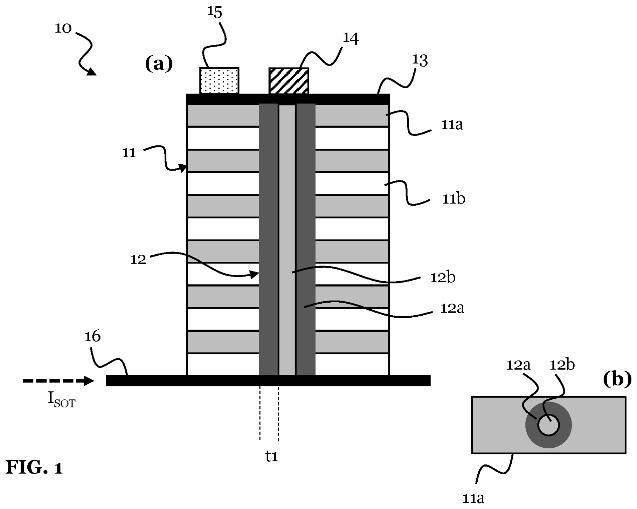

FIG. 1 shows an example of a 3D magnetic memory device 10 according to this invention. FIG. 1(a) shows a cross-sectional side view, and FIG. 1(b) shows a cross-sectional top view.

Like all examples of 3D magnetic memory devices 10 presented in this disclosure, the 3D magnetic memory device 10 of FIG. 1 comprises a layer stack 11, which comprises a plurality of dielectric layers 11a (e.g., silicon oxide layers or silicon layers) and a plurality of silicon-based layers 11b (e.g., silicon nitride layers or silicon germanium layers), which are alternatingly arranged one on the other. Through this stack 11 a magnetic channel 12 is formed. The magnetic channel 12 extends through each layer 11a, 11b of the stack 11. The magnetic channel 12 may extend along a first direction, which corresponds to a stacking direction of the layers 11a, 11b of the stack 11. This first direction may be referred to as the 'vertical direction', as it is oriented in FIG. 1. The magnetic channel 12 may thus extend perpendicular to the surfaces of the layers 11a, 11b of the stack 11. However, it is also possible that the magnetic channel 12 extends in an angle to the surfaces of the layers 11a, 11b.

As can be further seen in FIG. 1, and as is common to all examples of 3D magnetic memory devices 10 presented in this disclosure, the magnetic channel 12 comprises a hollow cylinder 12a made of a magnetic material, and comprises a dielectric material 12b that fills the (inner core of the) hollow cylinder 12a. Accordingly, the magnetic channel 12 is referred to as a macaroni channel or a macaroni-type channel, with reference to similar channels in 3D NAND devices.

The hollow cylinder 12a may have a constant wall thickness along its length of extension through the stack 11. The hollow cylinder 12a may have a constant outer diameter along its length. A diameter of the inner core of the hollow cylinder 12a, which is filled by the dielectric material 12b, may be constant as well. The dielectric material 12b also has a cylindrical shape in this case.

The magnetic material of the hollow cylinder 12a may be or comprise a ferromagnetic or ferrimagnetic material. Alternatively or additionally, it may be or comprise a conductive material. As an example, the magnetic material may comprise at least one of cobalt, iron, nickel, or an alloy of these. The magnetic material may also be any of the former in addition to boron. The dielectric material 12b may be an oxide, for instance, silicon oxide.

Due to the alternation of the layers 11a, 11b of the stack 11, a plurality of pinning sites, defined by the plurality of layers 11a, 11b of the stack, are formed in the magnetic channel 12. Each of these pinning sites is configured to stabilize and this store one magnetic bit.

The magnetic memory device 10 of each example in this disclosure, as is shown in FIG. 1, further comprises a first metallic layer 13, which is arranged on a first end of the magnetic channel 12 and is arranged on the last layer of the stack 11. The 'last layer' relates to the arrangement of the layers 11a, 11b along the stacking direction of the layers 11a, 11b during the fabricating the stack 11, from a first layer of the stack to the last layer of the stack 11. The last layer may be a dielectric layer 11a as shown or a silicon-based layer 11b. On the first metallic layer 13, a MTJ 14 is arranged. In addition, a first electrode 15 (also referred to as the 'top electrode') is arranged on the first metallic layer 13 and at a distance to the MTJ 14. The MTJ 14 comprises at least a free layer, a reference layer, and a tunnel barrier layer, so that it enables measuring TMR as known from conventional MRAM. Advantageously, the MTJ 14 may comprises a magnetic free layer that has a coercivity of equal to or less than 20-40 mT, or in a range of 2-3 mT.

As shown for the example of FIG. 1, the MTJ 14 may be arranged directly above the first end of the magnetic channel 12 on the first metallic layer 13.

As also shown for the example of FIG. 1, the magnetic memory device 10 may comprise a second metallic layer 16, which is configured as an SOT track. The second end of the magnetic channel 12 and the first layer of the stack 11 are arranged on the second metallic layer 16 in this case. The first layer of the stack 11 may be a silicon-based layer 11n as shown, or a dielectric layer 11a. Being configured as an SOT track means that the second metallic layer 16 may be made of a certain material, may have a certain thickness, and may be connected to suitable electrodes, in order to allow passing an SOT current (I_{SOT}) through the second metallic layer 16. Passing the SOT current through the SOT track causes a magnetic bit to be written, by SOT, into the magnetic channel, wherein the magnetic bit is stabilized and thus stored by the pinning site defined by the layer of the stack 11 that is closest to the second metallic layer 16, as will be explained later.

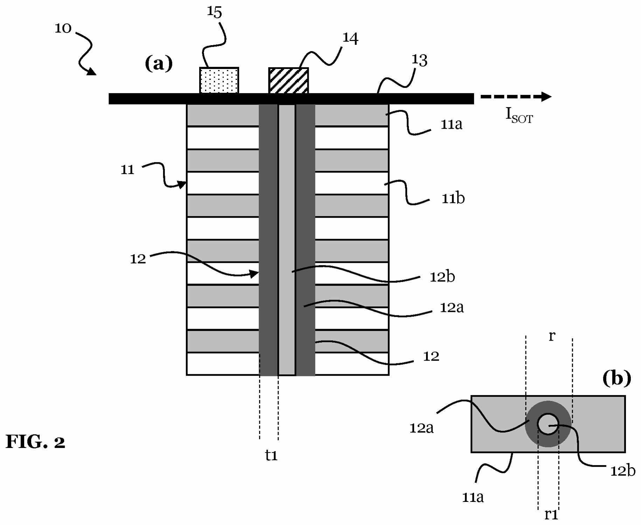

FIG. 2 shows another example of a 3D magnetic memory device 10 according to this invention. FIG. 2(a) shows a cross-sectional side view, and FIG. 2(b) shows a cross-sectional top view. Same elements of the 3D magnetic memory devices 10 in FIG. 1 and FIG. 2 share the same reference signs and may be implemented likewise.

As shown for the example of FIG. 2, instead of comprising the second metallic layer 16, like the 3D magnetic memory device 10 of FIG. 1, the first metallic layer 13 may be configured as a SOT track. That is, the first metallic layer 13 may be made of a certain material, may have a certain thickness, and may be connected to suitable electrodes, to allow passing an SOT current I_{SOT} through the first metallic layer 13. This causes a magnetic bit to be written by SOT into the magnetic channel 12, which is stabilized and thus stored by the pinning site defined by the layer of the stack 11 that is closest to the first metallic layer 13.

At least one of the first metallic layer 13 and the second metallic layer 16, particularly at least that metallic layer 13, 16, which is configured as the SOT track, may be made of tantalum nitride, tungsten nitride, tungsten, tantalum, platinum, hafnium, molybdenum, molybdenum nitride, or alloys thereof, or of a topological insulator.

At the first end of the magnetic channel 12, an inner core of the hollow cylinder 12a has a radius *r1* of up to 100 nm or in a range of 10-80 nm. Exemplarily, the magnetic channel 12 may further have an outer diameter *r*, which may correspond to the *CD.* The magnetic channel 12 may further have a height or length *T* along its extension direction through the stack 11. This length *T* may be subdivided into *n* magnetic cells representing each a magnetic bit. Each magnetic cell may have a height or thickness of *t,* such that the product of *n* and *t* equals the height *T*. In conventionally designed devices, *CD* can take values around 30, 50, and/or 80 nm, whereas *t* can take values ranging from 15 to 50 nm. Also, depending on the magnetic orientation within the domain of a given cell, the magnetic bit can take either a value of 0 or 1.

FIG. 1(b) and FIG. 2(b) show that the shape of the magnetic channel 12 is a "donut" or ring shape (when viewed from the top, i.e., along the extension of the magnetic channel 12). This allows the reduction of the active surface area, through which the current has to run. By reducing the surface area in this way, similar results in terms of current reduction can be achieved, as if the magnetic memory device 10 was scaled down. This has the benefit of avoiding such down-scaling, which would lead to a more challenging and costly fabrication process.

Moreover, the dielectric material core 12b reduces the stray field, but an acceptable reduction can be chosen in such a way that the aspect ratio of the macaroni channel can diverge more from the elongated configuration, while keeping a stable magnetic orientation.

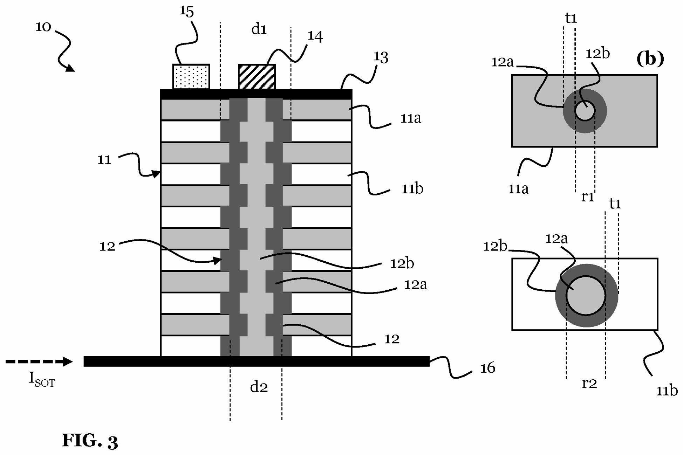

FIG. 3 shows another example of a 3D magnetic memory device 10 according to this invention. FIG. 3(a) shows a cross-sectional side view, and FIG. 3(b) shows a cross-sectional top view. Same elements of the 3D magnetic memory devices 10 in FIG. 1 and FIG. 3 share the same reference signs.

In the 3D magnetic memory device 10 of FIG. 3, the magnetic channel 12 has a first (outer) diameter d1 where it extends through a silicon-based layer 11b, and has a second (outer) diameter d2 where it extends through a dielectric layer 11a of the stack 11. That is, the magnetic channel 12 has a varying diameter. This may be achieved by partly recessing either the silicon-based layers 11b or the dielectric layers 11a of the stack 11 during the fabrication of the memory device 10, before forming the magnetic channel 12. For example, the first diameter may be larger than the second diameter, as shown in FIG. 1, but this can also be the other way around.

The hollow cylinder 12a may be a stepped hollow cylinder 12a, as it may comprise step-like diameter changes. However, the stepped hollow cylinder 12a may have a constant wall thickness. That is, the hollow cylinder 12a may be stepped both on its outer surface and on its inner surface to the inner core. Also the dielectric material 12b, which may be an oxide in this invention, may have a stepped cylindrical shape.

It may be beneficial for the pinning sites formed along the magnetic channel 12, if the transitions between the first diameter d1 and the second diameter d2 are aligned with the interfaces between the alternatingly arranged layers 11a, 11b of the stack 11. In the case of the magnetic macaroni channel 12 having varying diameter (d1 and d2), the recesses can also play a role of enhancing the pinning sites in-between magnetic domains. Therefore, this configuration may provide a nearly point-like pinning instead of layer pinning, and each individual layer 11a, 11b in the stack 11 can be exploited for a pinning site (instead of only bilayers).

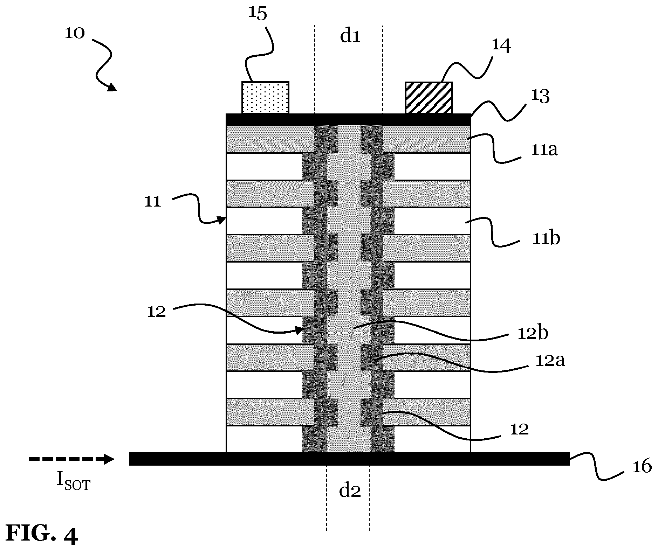

FIG. 4 shows another example of a 3D magnetic memory device 10 according to this invention. Same elements of the memory devices 10 in FIG. 4 and in the previous figures share the same reference signs and may be implemented likewise. The 3D magnetic memory device 10 of FIG. 4 is similar to that of FIG. 3, as it comprises a magnetic channel 12 with varying diameter (d1 and d2). However, the magnetic memory device 10 could also comprise a magnetic channel 12 as shown in FIG. 1 or FIG. 2. That is, the features described in the following are compatible with the constant-diameter magnetic channel 12 of FIG. 1 and FIG. 2.

As shown for the example of FIG. 4, the MTJ 14 may be arranged offset from the first end of the magnetic channel 12, i.e., it is in this case not positioned directly above said first end of the magnetic channel 12. The MTJ 14 may thus be either closer to or further away from the first electrode 15 as in the example shown in FIG. 3. The MTJ 14 is also referred to as being arranged out-of-plane in this case.

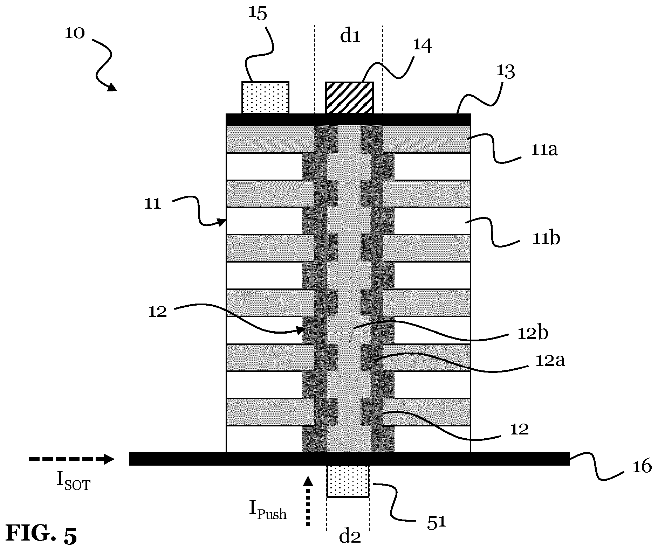

FIG. 5 shows another example of a 3D magnetic memory device 10 according to this invention. Same elements of the magnetic memory devices 10 shown in FIG. 5 and the previous figures share the same reference signs and may be implemented likewise. The example of FIG. 5 builds particularly on the example of FIG. 3, as it comprises the magnetic channel 12 with varying diameter (d1 and d2). However, the following features are also applicable to the magnetic memory devices 10 of the examples of FIG. 1 and 2, i.e., with a magnetic channel 12 of constant diameter.

As shown for the example of FIG. 5, the 3D magnetic memory device 10 may comprise a second electrode 51 (also referred to as 'bottom electrode'), which is arranged on or directly below a second end of the magnetic channel 12. The second electrode 51 may be placed on the second metallic layer 16, as shown. However, in the absence of the second metallic layer 16, like in the example of FIG. 2, the second electrode 51 could be placed directly on the second end of the magnetic channel 12 and the first layer of the stack 11. The second electrode 51 may allow sending a push current I_{Push} into the magnetic channel 12 and towards the first electrode 15.

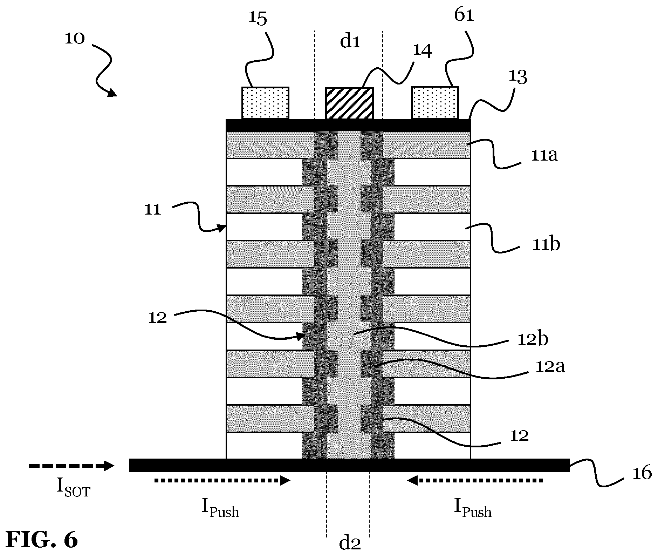

FIG. 6 shows another example of a 3D magnetic memory device 10 according to this invention. Same elements of the memory devices 10 shown in FIG. 6 and the previous figures share the same reference signs and may be implemented likewise. The example of FIG. 6 builds particularly on the example of FIG. 3, as it comprises the magnetic channel 12 with varying diameter (d1 and 2). However, the following features are also applicable to the magnetic memory devices 10 of the examples of FIG. 1 and 2, i.e., with a magnetic channel 12 of constant diameter.

As shown for the example of FIG. 6, the magnetic memory device 10 may comprise a further first electrode 61 (also referred to as 'further top electrode'). Further, the magnetic memory device 10 may comprise no second electrode 51 at the bottom, as in FIG. 5. Without the second electrode 51, a more compact memory cell of the memory device 10 may be obtained, which may lead to a smaller footprint of the memory device 10 comprising multiple such memory cells. In the example of FIG. 6, the push current I_{Push} may be provided by sending current through both sides of the SOT track provided by the second metallic layer 16. In particular, the current is pushed from both sides to limit the current density in the second metallic layer 16, and to increase its endurance and reliability.

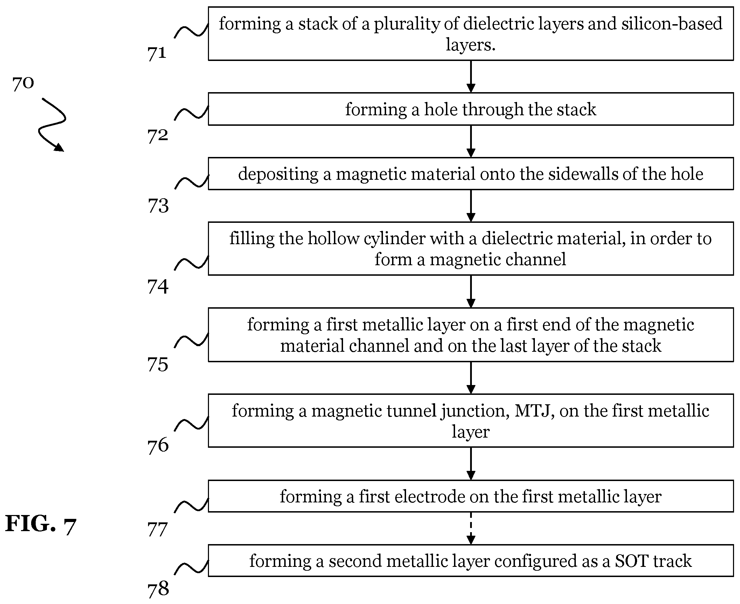

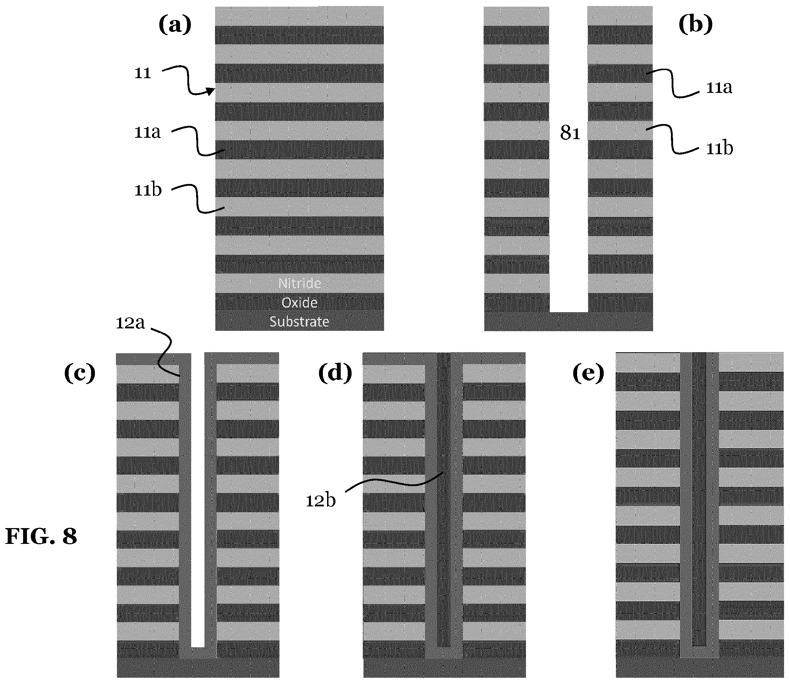

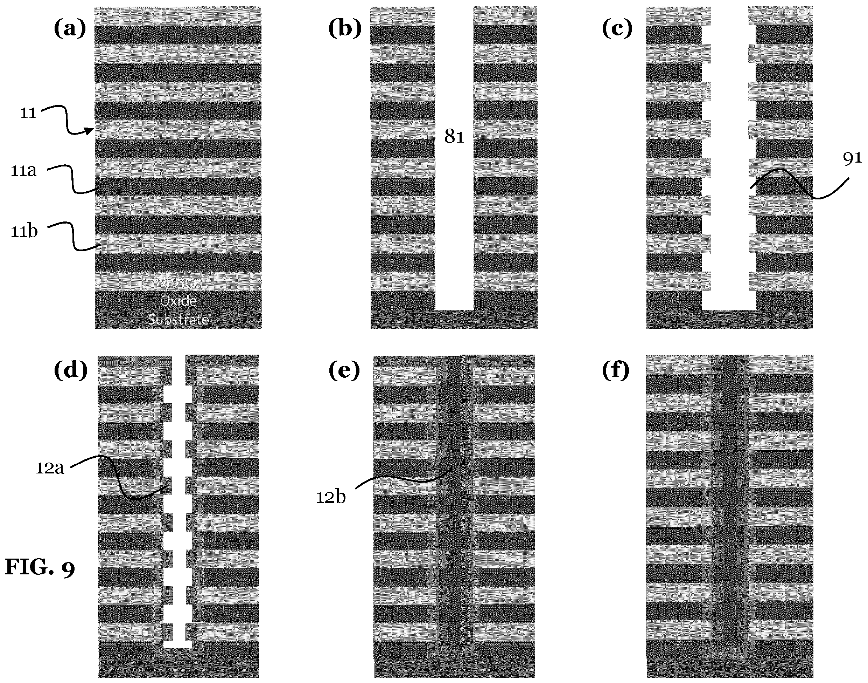

FIG. 7 shows a flow-diagram of a method 70 of this invention for fabricating the 3D magnetic memory device 10, wherein the method 70 may be applicable to all previous examples. FIG. 8 and FIG. 9 show exemplary illustrations of exemplary implementations of the method 70. FIG. 8 relates to a 3D magnetic memory device 10 having a magnetic channel 12 with a constant diameter, while FIG. 9 relates to a 3D magnetic memory device 10 having a magnetic channel 12 with a varying diameter.

As shown in FIG. 7, the method 70 comprise a step 71 of forming the stack 11 of a plurality of dielectric layers 11a and silicon-based layers 11b, which are alternatingly arranged one on the other (see also FIG. 8(a) and FIG. 9(a)). The method 70 further comprises a step 72 of forming a hole 81 through the stack 11, wherein the hole 81 extends through the layers 11a, 11b of the stack 11 (see also FIG. 8(b) and FIG. 9(b)). The method 70 then comprises a step 73 of depositing a magnetic material onto the sidewalls of the hole, in order to form a hollow cylinder 12a made of the magnetic material (see also FIG. 8(c) and FIG. 9(d)). The magnetic material may be formed by conformal deposition on the sidewalls of the hole 81, which is why some magnetic material may also deposit on the bottom surface of the hole 81, as shown. Then, the method 70 comprises a step 74 of filling the hollow cylinder 12a with a dielectric material 12b, in order to form a magnetic channel comprising the hollow cylinder 12a and the dielectric filling material 12b (see also FIG. 8(d) and FIG. 9(e)). Notably, in FIG. 8(e) and FIG. 9(f), some magnetic material that is deposited on the top surface of the stack 11, while forming the hollow cylinder 12, may be removed, in order to allow the subsequent steps including forming the first metallic layer 13.

As further shown in FIG. 7, the method 70 accordingly comprises a step 75 of forming the first metallic layer 13 on the first end of the magnetic channel 12 and on the last layer of the stack 11, and a step 76 of forming the MTJ 14 on the first metallic layer 13. Then, the method 70 further comprises a step 77 of forming the first electrode 15 on the first metallic layer 13 at a distance to the MTJ 14.

If the 3D magnetic memory device 10 is an example as shown in FIG. 3-6 (i.e. has a magnetic channel 12 with a varying diameter), the method 70 may comprise the following steps. After forming the hole 81, the method 70 may comprise a step of selectively etching from within the hole 81, in order form recesses 91 of either the dielectric layers 11a or the silicon-based layers 11b, so as to partially broaden the hole (see FIG. 9(c)). The step 73 may then comprise depositing the magnetic material onto the sidewalls of the recessed hole 81, in order to form a stepped hollow cylinder 12a made of the magnetic material (see FIG. 9(d)). After the step 74 of filling the magnetic material into the stepped hollow cylinder 12a, a magnetic channel 12 with varying diameter may be formed. That is, a magnetic channel 12, which has the first diameter d1 where it extends through a silicon-based layer 11b of the stack and the second diameter d2 where it extends through a dielectric layer 11a of the stack 11. Notably, FIG. 9(c) shows that the dielectric layers 11a are recessed in this case, so that in the end the first diameter d1 will be smaller than the second diameter d2 in this case.

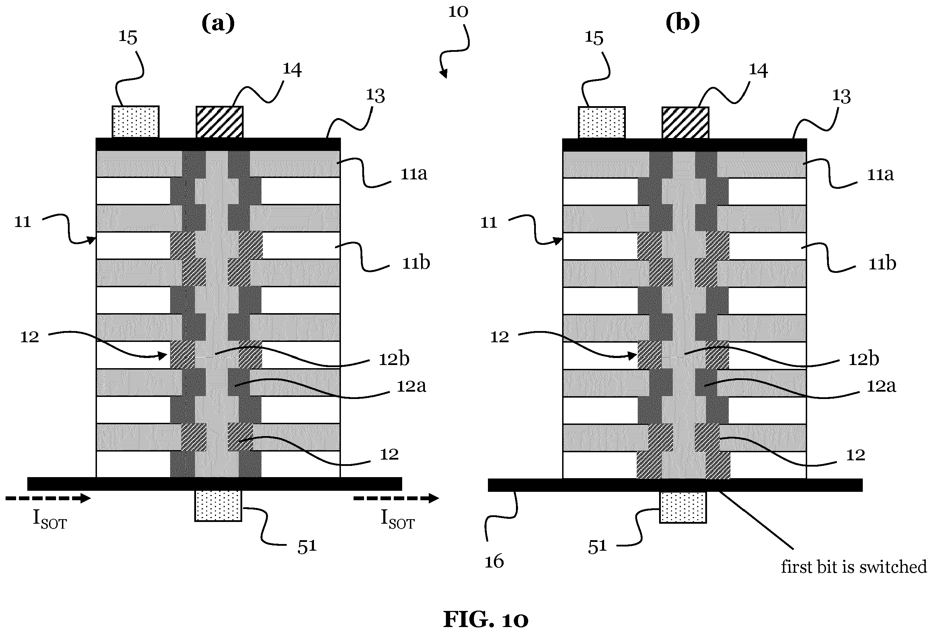

FIG. 10 shows an example of writing a magnetic bit into a magnetic memory device 10 according to this disclosure. FIG. 10 shows in particular the example of the 3D magnetic memory device 10 illustrated in FIG. 5 for demonstrating the writing operation. FIG. 10(a) shows the magnetic memory device 10 before/during the writing operation, while FIG. 10(b) shows the magnetic memory device 10 after the writing operation.

The writing of the magnetic bit into the magnetic channel 12 is caused by passing the current I_{SOT} through the second metallic layer 16, which is configured as the SOT track. The magnetic bit is written into the magnetic channel 12 and stored by the pinning site in the magnetic channel 12, which is closest to the SOT track, i.e., the pinning site corresponding to the first layer of the magnetic channel 12. A positive or negative current I_{SOT} will determine the writing of the magnetic bit as 'up' or 'down' (for the case of perpendicular magnetization) or 'left' or 'right' (for the case of in-plane magnetization). For instance, in FIG. 10(b), the writing of the magnetic bit has resulted in a switching of the bit, i.e., a switching of the magnetization stabilized by the corresponding pinning site.

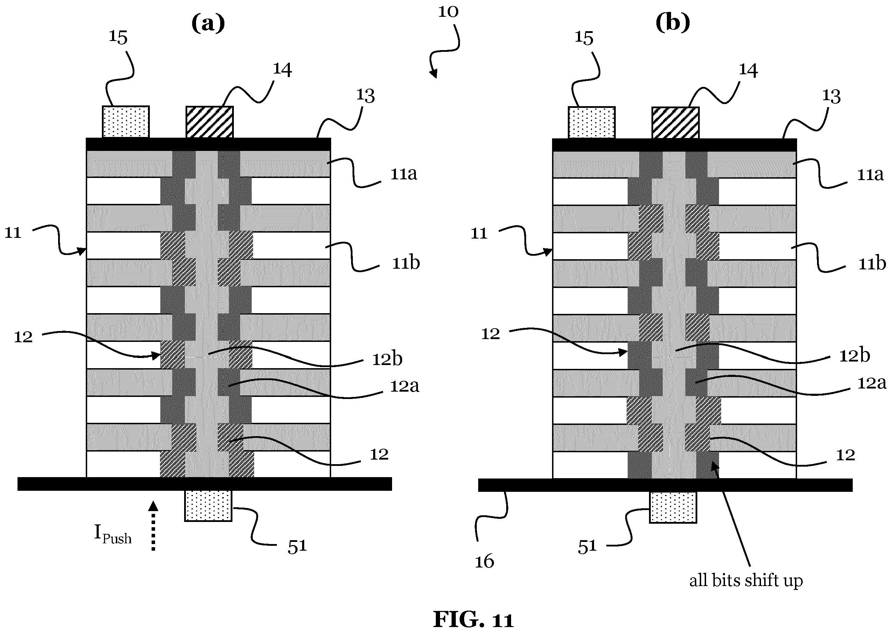

FIG. 11 shows an example of pushing magnetic bits in a magnetic memory device 10 according to this disclosure. FIG. 11 shows in particular the example of the 3D magnetic memory device 10 of FIG. 5 for demonstrating the pushing operation, following the writing operation shown in FIG. 11. The pushing of the magnetic bits moves the magnetic bits along the magnetic channel 12 from one pinning site to the next pinning site. As the example of FIG. 5 is used, magnetic bits are pushed upwards in the magnetic channel 12 in FIG. 11, i.e., towards the MTJ 14.

The magnetic bits are pushed by passing a current I_{Push} through the first electrode 15. In FIG. 11, the current is sent into the second electrode 41 towards the first electrode 15. If there would be no second electrode 51, the current I_{Push} could be sent towards the first electrode 15 as illustrated in FIG. 6, namely using the second metallic layer 16. During the pushing operation, a pulse timing may beneficially coincide with a domain wall movement of one period (movement of one pinning site). The push current I_{Push} will shift all magnetic bits (pinned magnetic domains) upwards by one pinning site. At the top of the magnetic channel 12 in FIG. 7, the surface of the first end of the magnetic channel 12 is advantageously flat, e.g., it may be flattened by chemical mechanic polishing (CMP). The first metallic layer 13 may function as a thin metallic spacer layer in this case (wherein it could be made of TaN), in order to provide a path for the current to go to the first electrode 15.

For reading a magnetic bit, the magnetic state of the uppermost magnetic bit may be sensed in the 3D magnetic memory device 10 according to the example of FIG. 5. This can be done by using the top-pinned MTJ 14. The free layer of the MTJ 14 may be deposited in direct contact with the first metallic layer 13. The free layer may have the above-mentioned low coercivity of 40 mT or less, such that the stray magnetic field of the top magnetic bit (e.g., 'up' or 'down', higher than the free layer coercivity) may determine the orientation of the free layer. The actual sensing can then be done by reading the resistance of the MTJ 14 and the TMR effect.

Since, in this example, the magnetic bit reaching the top of the magnetic channel 12 - which may be read using the MTJ 14 - will be annihilated at the next push, the read operation of the magnetic memory device 10 may be a destructive read. The magnetic bit may then either be re-written at the bottom of the magnetic channel 12, i.e., at the SOT track, or may be stored in a buffer memory, for instance, for a later burst write.

The magnetic memory device 10 may, for example, operate in a 'full string' writing and/or reading mode. This means that the smallest addressable bit-length may be equal to the number of layers 11a/11b in the stack 11. However, the operation mode of the magnetic memory device 10 may also be determined by architectural choices on the array and system level.

As has been explained, the memory architecture of the magnetic memory device 10 of this disclosure comprises a sequential read/write structure, wherein magnetic bits are vertically stacked in the form of oriented magnetic domains (stabilized by the pinning sites) inside and along the magnetic channel 12 comprising the magnetic material (e.g., cobalt, nickel, iron, alloys thereof,...). The domain pinning is achieved by using the layer stack 11 (e.g., a SiN/SiO matrix) with a morphology depending on the applications of interest.

On the one hand, writing may be performed at the bottom of the stack 11 by injecting a current through a SOT generating track, which enables the bottom-most magnetic bit to have an orientation depending on the current's polarity. On the other hand, reading may be performed at the top, through the MTJ 14 used to sense the magnetic stray field of the topmost pinning site by reading the resistance of the MTJ 14 and through the TMR effect. After a writing operation, the magnetic bits may be pushed upwards by applying a current from the electrode at the bottom of the stack 11 to the electrode at the top through the magnetic channel 12.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A three dimensional, 3D, magnetic memory device (10), the 3D magnetic memory device (10) comprising:
a stack (11) comprising a plurality of dielectric layers (11a) and silicon-based layers (11b), which are alternatingly arranged one on the other;
a magnetic channel (12) that extends through the layers (11a, 11b) of the stack (11),
wherein the magnetic channel (12) comprises a hollow cylinder (12a) made of a magnetic material, and a dielectric material (12b) that fills the hollow cylinder (12a);
wherein a plurality of pinning sites defined by the plurality of layers (11a, 11b) of the stack (12) is formed in the magnetic channel (12), each pinning site being configured to store one magnetic bit;
a first metallic layer (13) arranged on a first end of the magnetic channel (12) and on the last layer of the stack (11);
a magnetic tunnel junction, MTJ, (14) arranged on the first metallic layer (13); and
a first electrode (15) arranged on the first metallic layer (13) at a distance to the MTJ (14);
wherein either the first metallic layer (13) is configured as a spin-orbit-torque, SOT, track, or the magnetic memory device (10) comprises a second metallic layer (16) configured as a SOT track and a second end of the magnetic channel (12) and the first layer of the stack (11) are arranged on the second metallic layer (16).

2. The 3D magnetic memory device (10) of claim 1, wherein the magnetic channel (12) has a first diameter (d1) where it extends through a silicon-based layer (11b) and has a second diameter (d2) where it extends through a dielectric layer (11a) of the stack (11).

3. The 3D magnetic memory device of claim 2, wherein the first diameter (d1) is larger than the second diameter (d2).

4. The 3D magnetic memory device (10) of claim 2 or 3, wherein a ratio between the first diameter (d1) and the second diameter (d2) is in a range of 1.1:1 to 2:1.

5. The 3D magnetic memory device (10) of one of the claims 2 to 4, wherein transitions between the first diameter (d1) and the second diameter (d2) are aligned with interfaces between the alternatingly arranged layers (11a, 11b) of the stack (11).

6. The 3D magnetic memory device (10) of one of the claims 2 to 5, wherein the hollow cylinder (12a) is a stepped hollow cylinder (12a).

7. The 3D magnetic memory device (10) of claim 6, wherein the stepped hollow cylinder (12a) has a constant wall thickness (t1).

8. The 3D magnetic memory device (10) of one of the claims 1 to 7, wherein at the first end of the magnetic channel (12), an inner core of the hollow cylinder (12a) has a radius (r1) of up to 100 nm or in a range of 10-80 nm.

9. The 3D magnetic memory device (10) of one of the claims 1 to 8, wherein a length (T) of the magnetic channel (12) along an extension direction of the magnetic channel (12) through the stack (11) is in a range of 5-150 nm times the number of layers (11a, 11b) of the stack (11).

10. The 3D magnetic memory device (10) of one of the claims 1 to 9, wherein the magnetic material of the hollow cylinder (12a) is a ferromagnetic or ferrimagnetic material and/or a conductive material, for example, is cobalt, iron, nickel, or an alloy thereof, or is any of the former in addition to boron.

11. The 3D magnetic memory device (10) of one of the claims 1 to 10, wherein:
the dielectric layers (11a) are silicon oxide layers and the silicon-based layers (11b) are silicon nitride layers, or the dielectric layers (11a) are silicon layers and the silicon-based layers (11b) are silicon germanium layers; and/or
the dielectric material (12b) that fills the hollow cylinder (12a) is silicon oxide.

12. The 3D magnetic memory device (10) of one of the claims 1 to 11, further comprising a second electrode (51) arranged on or directly below the second end of the magnetic channel (12).

13. A method (70) of fabricating a 3D magnetic memory device (10), the method (70) comprising:
forming (71) a stack (11) of a plurality of dielectric layers (11a) and silicon-based layers (11b), which are alternatingly arranged one on the other;
forming (72) a hole (81) that extends through the layers (11a, 11b) of the stack (11);
depositing (73) a magnetic material onto the sidewalls of the hole (81), in order to form a hollow cylinder (12a) made of the magnetic material;
filling (74) the hollow cylinder (12a) with a dielectric material (12b), in order to form a magnetic channel (12) comprising the hollow cylinder (12a) and the dielectric material (12b);
wherein a plurality of stacked pinning sites defined by the plurality of layers (11a, 11b) of the stack (11) is formed in the magnetic channel (12), each pinning site being configured to store one magnetic bit;
forming (75) a first metallic layer (13) on a first end of the magnetic channel (12) and on the last layer of the stack (11);
forming (76) a magnetic tunnel junction, MTJ, (14) on the first metallic layer (13); and
forming (77) a first electrode (15) on the first metallic layer (13) at a distance to the MTJ (14);
wherein either the first metallic layer (13) is configured as a spin-orbit-torque, SOT, track, or the method (70) further comprises forming a second metallic layer (16) configured as a SOT track and arranging a second end of the magnetic channel (12) and the first layer of the stack (11) on the second metallic layer (16).

14. The method (70) of claim 13, comprising:
after forming (72) the hole (81), selectively etching from within the hole (81) to recess (91) either the dielectric layers (11a) or the silicon-based layers (11b), in order to partially broaden the hole (81); and
depositing (73) the magnetic material onto the sidewalls of the recessed hole (81), in order to form a stepped hollow cylinder (12a) made of the magnetic material.

15. The method (10) of claim 13 or 14, wherein the magnetic material is formed by conformal deposition on the sidewalls of the hole (81) and/or is deposited to a thickness in a range of 5-20 nm.

## Patentansprüche

1. Dreidimensionale, 3D, Magnetspeichervorrichtung (10), wobei die 3D-Magnetspeichervorrichtung (10) Folgendes umfasst:
einen Stapel (11), der eine Mehrzahl von dielektrischen Schichten (11a) und siliziumbasierten Schichten (11b) umfasst, die abwechselnd übereinander angeordnet sind;
einen Magnetkanal (12), der sich durch die Schichten (11a, 11b) des Stapels (11) erstreckt,
wobei der Magnetkanal (12) einen Hohlzylinder (12a), der aus einem magnetischen Material hergestellt ist, und ein dielektrisches Material (12b) umfasst, das den Hohlzylinder (12a) füllt;
wobei eine Mehrzahl von Verstiftungsstellen, die durch die Mehrzahl von Schichten (11a, 11b) des Stapels (12) definiert ist, in dem Magnetkanal (12) ausgebildet ist,
wobei jede Verstiftungsstelle dazu ausgelegt ist, ein magnetisches Bit zu speichern;
eine erste Metallschicht (13), die an einem ersten Ende des Magnetkanals (12) und auf der letzten Schicht des Stapels (11) angeordnet ist;
einen Magnettunnelübergang, MTJ, (14), der auf der ersten Metallschicht (13) angeordnet ist, und
eine erste Elektrode (15), die auf der ersten Metallschicht (13) in einem Abstand zum MTJ (14) angeordnet ist;
wobei entweder die erste Metallschicht (13) als Spin-Orbit-Torque-Leiterbahn, SOT-Leiterbahn, ausgelegt ist oder die Magnetspeichervorrichtung (10) eine zweite Metallschicht (16) umfasst, die als SOT-Leiterbahn ausgelegt ist, und ein zweites Ende des Magnetkanals (12) und die erste Schicht des Stapels (11) auf der zweiten Metallschicht (16) angeordnet sind.

2. 3D-Magnetspeichervorrichtung (10) nach Anspruch 1, wobei der Magnetkanal (12) dort, wo er sich durch eine siliziumbasierte Schicht (11b) erstreckt, einen ersten Durchmesser (d1) und dort, wo er sich durch eine dielektrische Schicht (11a) des Stapels (11) erstreckt, einen zweiten Durchmesser (d2) aufweist.

3. 3D-Magnetspeichervorrichtung nach Anspruch 2, wobei der erste Durchmesser (d1) größer ist als der zweite Durchmesser (d2).

4. 3D-Magnetspeichervorrichtung (10) nach Anspruch 2 oder 3, wobei ein Verhältnis zwischen dem ersten Durchmesser (d1) und dem zweiten Durchmesser (d2) in einem Bereich von 1,1:1 bis 2:1 liegt.

5. 3D-Magnetspeichervorrichtung (10) nach einem der Ansprüche 2 bis 4, wobei Übergänge zwischen dem ersten Durchmesser (d1) und dem zweiten Durchmesser (d2) mit Grenzflächen zwischen den abwechselnd angeordneten Schichten (11a, 11b) des Stapels (11) ausgerichtet sind.

6. 3D-Magnetspeichervorrichtung (10) nach einem der Ansprüche 2 bis 5, wobei der Hohlzylinder (12a) ein gestufter Hohlzylinder (12a) ist.

7. 3D-Magnetspeichervorrichtung (10) nach Anspruch 6, wobei der gestufte Hohlzylinder (12a) eine konstante Wanddicke (t1) aufweist.

8. 3D-Magnetspeichervorrichtung (10) nach einem der Ansprüche 1 bis 7, wobei an dem ersten Ende des Magnetkanals (12) ein innerer Kern des Hohlzylinders (12a) einen Radius (r1) von bis zu 100 nm oder in einem Bereich von 10-80 nm aufweist.

9. 3D-Magnetspeichervorrichtung (10) nach einem der Ansprüche 1 bis 8, wobei eine Länge (T) des Magnetkanals (12) entlang einer Erstreckungsrichtung des Magnetkanals (12) durch den Stapel (11) in einem Bereich von 5-150 nm mal der Anzahl von Schichten (11a, 11b) des Stapels (11) liegt.

10. 3D-Magnetspeichervorrichtung (10) nach einem der Ansprüche 1 bis 9, wobei das magnetische Material des Hohlzylinders (12a) ein ferromagnetisches oder ein ferrimagnetisches Material ist oder ein leitfähiges Material, beispielsweise Kobalt, Eisen, Nickel oder eine Legierung davon, ist oder eines der ersteren zusätzlich zu Bor ist.

11. 3D-Magnetspeichervorrichtung (10) nach einem der Ansprüche 1 bis 10, wobei:
die dielektrischen Schichten (11a) Siliziumoxidschichten sind und die siliziumbasierten Schichten (11b) Siliziumnitridschichten sind oder die dielektrischen Schichten (11a) Siliziumschichten sind und die siliziumbasierten Schichten (11b) Silizium-Germanium-Schichten sind; und/oder
das dielektrische Material (12b), das den Hohlzylinder (12a) füllt, Siliziumoxid ist.

12. 3D-Magnetspeichervorrichtung (10) nach einem der Ansprüche 1 bis 11, ferner umfassend eine zweite Elektrode (51), die an oder direkt unter dem zweiten Ende des Magnetkanals (12) angeordnet ist.

13. Verfahren (70) zur Herstellung einer 3D-Magnetspeichervorrichtung (10), wobei das Verfahren (70) Folgendes umfasst:
Bilden (71) eines Stapels (11) einer Mehrzahl von dielektrischen Schichten (11a) und siliziumbasierten Schichten (11b), die abwechselnd übereinander angeordnet sind;
Bilden (72) eines Lochs (81), das sich durch die Schichten (11a, 11b) des Stapels (11) erstreckt;
Abscheiden (73) eines magnetischen Materials auf die Seitenwände des Lochs (81), um einen Hohlzylinder (12a) zu bilden, der aus dem magnetischen Material hergestellt ist;
Füllen (74) des Hohlzylinders (12a) mit einem dielektrischen Material (12b), um einen Magnetkanal (12) zu bilden, der den Hohlzylinder (12a) und das dielektrische Material (12b) umfasst;
wobei eine Mehrzahl von gestapelten Verstiftungsstellen, die durch die Mehrzahl von Schichten (11a, 11b) des Stapels (11) definiert ist, in dem Magnetkanal (12) ausgebildet ist, wobei jede Verstiftungsstelle dazu ausgelegt ist, ein magnetisches Bit zu speichern;
Bilden (75) einer ersten Metallschicht (13) an einem ersten Ende des Magnetkanals (12) und auf der letzten Schicht des Stapels (11);
Bilden (76) eines Magnettunnelübergangs, MTJ, (14) auf der ersten Metallschicht (13) und
Bilden (77) einer ersten Elektrode (15) auf der ersten Metallschicht (13) in einem Abstand zum MTJ (14);
wobei entweder die erste Metallschicht (13) als Spin-Orbit-Torque-Leiterbahn, SOT-Leiterbahn, ausgelegt ist oder das Verfahren (70) ferner Bilden einer zweiten Metallschicht (16), die als SOT-Leiterbahn ausgelegt ist, und Anordnen eines zweiten Endes des Magnetkanals (12) und der ersten Schicht des Stapels (11) auf der zweiten Metallschicht (16) umfasst.

14. Verfahren (70) nach Anspruch 13, umfassend:
nach dem Bilden (72) des Lochs (81) selektives Ätzen von innerhalb des Lochs (81) zu der Vertiefung (91) entweder der dielektrischen Schichten (11a) oder der siliziumbasierten Schichten (11b), um das Loch (81) teilweise zu verbreitern; und
Abscheiden (73) des magnetischen Materials auf die Seitenwände des vertieften Lochs (81), um einen gestuften Hohlzylinder (12a) zu bilden, der aus dem magnetischen Material hergestellt ist.

15. Verfahren (10) nach Anspruch 13 oder 14, wobei das magnetische Material durch konforme Abscheidung auf die Seitenwände des Lochs (81) gebildet wird und/oder bis zu einer Dicke in einem Bereich von 5-20 nm abgeschieden wird.

## Revendications

1. Dispositif de mémoire magnétique tridimensionnel, 3D (10), le dispositif de mémoire magnétique 3D (10) comprenant :
un empilement (11) comprenant une pluralité de couches diélectriques (11a) et de couches à base de silicium (11b), qui sont disposées en alternance les unes sur les autres ;
un canal magnétique (12) qui s'étend à travers les couches (11a, 11b) de l'empilement (11),
le canal magnétique (12) comprenant un cylindre creux (12a) constitué d'un matériau magnétique, et un matériau diélectrique (12b) qui remplit le cylindre creux (12a),
une pluralité de sites d'ancrage définie par la pluralité de couches (11a, 11b) de l'empilement (12) étant formée dans le canal magnétique (12), chaque site d'ancrage étant conçu pour stocker un bit magnétique ;
une première couche métallique (13) disposée sur une première extrémité du canal magnétique (12) et sur la dernière couche de l'empilement (11) ;
une jonction tunnel magnétique, MTJ (14), disposée sur la première couche métallique (13) ; et
une première électrode (15) disposée sur la première couche métallique (13) à une certaine distance de la MTJ (14),
dans lequel soit la première couche métallique (13) est conçue comme une piste à couple spin-orbite, SOT, soit le dispositif de mémoire magnétique (10) comprend une deuxième couche métallique (16) conçue comme une piste SOT et une deuxième extrémité du canal magnétique (12) et la première couche de l'empilement (11) sont disposées sur la deuxième couche métallique (16).

2. Dispositif de mémoire magnétique 3D (10) de la revendication 1, dans lequel le canal magnétique (12) a un premier diamètre (d1) à l'endroit où il s'étend à travers une couche à base de silicium (11b) et a un deuxième diamètre (d2) à l'endroit où il s'étend à travers une couche diélectrique (11a) de l'empilement (11).

3. Dispositif de mémoire magnétique 3D de la revendication 2, dans lequel le premier diamètre (d1) est plus grand que le deuxième diamètre (d2).

4. Dispositif de mémoire magnétique 3D (10) de la revendication 2 ou 3, dans lequel un rapport entre le premier diamètre (d1) et le deuxième diamètre (d2) est compris entre 1,1/1 et 2/1.

5. Dispositif de mémoire magnétique 3D (10) d'une des revendications 2 à 4, dans lequel des transitions entre le premier diamètre (d1) et le deuxième diamètre (d2) sont alignées avec des interfaces entre les couches disposées en alternance (11a, 11b) de l'empilement (11).

6. Dispositif de mémoire magnétique 3D (10) d'une des revendications 2 à 5, dans lequel le cylindre creux (12a) est un cylindre creux étagé (12a).

7. Dispositif de mémoire magnétique 3D (10) de la revendication 6, dans lequel le cylindre creux étagé (12a) a une épaisseur de paroi constante (t1).

8. Dispositif de mémoire magnétique 3D (10) d'une des revendications 1 à 7 dans lequel, à la première extrémité du canal magnétique (12), une âme interne du cylindre creux (12a) a un rayon (r1) allant jusqu'à 100 nm ou compris entre 10 et 80 nm.

9. Dispositif de mémoire magnétique 3D (10) d'une des revendications 1 à 8, dans lequel une longueur (T) du canal magnétique (12) le long d'une direction d'extension du canal magnétique (12) à travers l'empilement (11) est comprise entre 5 et 150 nm multipliés par le nombre de couches (11a, 11b) de l'empilement (11).

10. Dispositif de mémoire magnétique 3D (10) d'une des revendications 1 à 9, dans lequel le matériau magnétique du cylindre creux (12a) est un matériau ferromagnétique ou ferrimagnétique et/ou un matériau conducteur, par exemple est le cobalt, le fer, le nickel ou un alliage de ceux-ci, ou est l'un quelconque des matériaux précédents complété de bore.

11. Dispositif de mémoire magnétique 3D (10) d'une des revendications 1 à 10, dans lequel :
les couches diélectriques (11a) sont des couches d'oxyde de silicium et les couches à base de silicium (11b) sont des couches de nitrure de silicium, ou bien les couches diélectriques (11a) sont des couches de silicium et les couches à base de silicium (11b) sont des couches de silicium-germanium ; et/ou
le matériau diélectrique (12b) qui remplit le cylindre creux (12a) est l'oxyde de silicium.

12. Dispositif de mémoire magnétique 3D (10) d'une des revendications 1 à 11, comprenant en outre une deuxième électrode (51) disposée sur ou juste en dessous de la deuxième extrémité du canal magnétique (12).

13. Procédé (70) de fabrication d'un dispositif de mémoire magnétique 3D (10), le procédé (70) comprenant :
la formation (71) d'un empilement (11) d'une pluralité de couches diélectriques (11a) et de couches à base de silicium (11b), qui sont disposées en alternance les unes sur les autres ;
la formation (72) d'un trou (81) qui s'étend à travers les couches (11a, 11b) de l'empilement (11) ;
le dépôt (73) d'un matériau magnétique sur les parois latérales du trou (81), de manière à former un cylindre creux (12a) constitué du matériau magnétique ;
le remplissage (74) du cylindre creux (12a) avec un matériau diélectrique (12b), de manière à former un canal magnétique (12) comprenant le cylindre creux (12a) et le matériau diélectrique (12b),
une pluralité de sites d'ancrage empilés définie par la pluralité de couches (11a, 11b) de l'empilement (11) étant formée dans le canal magnétique (12), chaque site d'ancrage étant conçu pour stocker un bit magnétique ;
la formation (75) d'une première couche métallique (13) sur une première extrémité du canal magnétique (12) et sur la dernière couche de l'empilement (11) ;
la formation (76) d'une jonction tunnel magnétique, MTJ (14), sur la première couche métallique (13) ; et
la formation (77) d'une première électrode (15) sur la première couche métallique (13) à une certaine distance de la MTJ (14),
dans lequel soit la première couche métallique (13) est conçue comme une piste à couple spin-orbite, SOT, soit le procédé (70) comprend en outre la formation d'une deuxième couche métallique (16) conçue comme une piste SOT et la mise en place d'une deuxième extrémité du canal magnétique (12) et de la première couche de l'empilement (11) sur la deuxième couche métallique (16).

14. Procédé (70) de la revendication 13, comprenant :
après la formation (72) du trou (81), une gravure sélective depuis l'intérieur du trou (81) pour évider (91) soit les couches diélectriques (11a), soit les couches à base de silicium (11b), de manière à élargir partiellement le trou (81) ; et
le dépôt (73) du matériau magnétique sur les parois latérales du trou évidé (81), de manière à former un cylindre creux étagé (12a) constitué du matériau magnétique.

15. Procédé (10) de la revendication 13 ou 14, dans lequel le matériau magnétique est formé par dépôt conforme sur les parois latérales du trou (81) et/ou est déposé sur une épaisseur comprise entre 5 et 20 nm.
